# EUROPÄISCHE PATENTSCHRIFT

(11) **EP 3 440 686 B1**
(45) Veröffentlichungstag und Bekanntmachung des Hinweises auf die Patenterteilung: **03.05.2023**
(21) Anmeldenummer: 17711171.3
(22) Anmeldetag: 16.03.2017
(51) Int. Cl.: H01H 9/54, H01H 33/04

(54) **SCHALTVORRICHTUNG ZUM FÜHREN UND TRENNEN VON ELEKTRISCHEN STRÖMEN**
SWITCHING DEVICE FOR CONDUCTING AND INTERRUPTING ELECTRICAL CURRENTS
DISPOSITIF DE COMMUTATION POUR ACHEMINER ET COUPER DES COURANTS ÉLECTRIQUES

(30) Priorität: 07.04.2016 DE 102016106415
(43) Veröffentlichungstag der Anmeldung: 13.02.2019
(73) Patentinhaber: Eaton Intelligent Power Limited, Dublin 4 (IE)
(72) Erfinder: SCHMITZ, Gerd, 53859 Niederkassel (DE); MEISSNER, Johannes, 53129 Bonn (DE); UEDELHOVEN, Marcel, 53945 Blankenheim (DE); WOHLANG, Michael, 53332 Bornheim (DE); KREFT, Oliver, 53119 Bonn (DE)
(74) Vertreter: Eaton IP Group EMEA
(86) Internationale Anmeldenummer: PCT/EP2017/056312
(87) Internationale Veröffentlichungsnummer: WO 2017/174326

(56) Entgegenhaltungen:
- EP-A1- 1 677 323
- EP-A1- 2 801 994
- DE-A1-102013 114 259
- US-A1- 2009 168 273

## Beschreibung

Die Erfindung betrifft eine Schaltvorrichtung zum Führen und Trennen von elektrischen Strömen, insbesondere eine Hybridschaltanordnung zum Führen und Trennen hoher DC-Ströme und niederfrequenter AC-Ströme, und ein Schaltgerät mit einer derartigen Schaltvorrichtung.

In der deutschen Offenlegungsschrift DE 10 2013 114 259 A1 ist eine vorteilhafte Variante einer Hybridschaltanordnung beschrieben, bei der die Strombelastung des Leistungshalbleiters zur Erzielung einer möglichst hohen Lebenserwartung sowie einer möglichst geringen Dimensionierung zeitlich minimiert ist, was vor allem bei Leistungsschützen im Strombereich einiger hundert Ampere wichtig ist. Zur zeitlichen Minimierung des durch den Leistungshalbleiter fließenden Laststroms wird über einen Stromwandler der Kommutierungszeitpunkt erfaßt und der Stromfluß durch den Halbleiter nur so lange aufrechterhalten, bis die sich öffnende mechanische Schaltstrecke eine ausreichende elektrische Festigkeit erreicht hat. In dieser kurzen Zeit wird der Laststrom durch den Halbleiter über dessen Ansteuerung künstlich zu Null geführt, so daß nach Öffnen sowohl der Löschkontakt- als auch der hierzu in Reihe geschalteten Trennkontaktanordnung eine sichere galvanische Trennung erzielt wird. Dennoch kann es bei dieser Hybridschaltanordnung unter bestimmten Umständen immer noch zu ungewollten Schaltlichtbögen kommen. Auch bei Hybridschaltern mit einer mechanischen Schaltanordnung in Form einer Vakuumschaltkammer zum Führen und Trennen sehr hoher Ströme, wie sie beispielsweise aus der deutschen Offenlegungsschrift DE 10 2013 114 260 A1 bekannt ist, kann es unter bestimmten Umständen zur Ausbildung ungewollter Schaltlichtbögen kommen.

Aus der europäischen Patentanmeldung EP 1677323A1 ist ein Verfahren zum Vermeiden von Kontaktabbrand in Niederspannungsleistungsschaltern bekannt, bei dem als Halbleiterschalter antiparallel-geschaltete Thyristoren eingesetzt werden. Um zu vermeiden, dass gezündete Thyristoren bei einem Nulldurchgang eines zu schaltenden Lastwechselstroms wieder sperren, wird ein, eine vorbestimmte Zeitdauer andauerndes, oszillierendes Steuersignal zum mehrmaligen aufeinanderfolgenden Einschalten der Halbleiterschalter generiert.

Aus der US-Patentanmeldung US 2009/168273 A1 ist eine Hybridschaltanordnung zum Führen und Trennen hoher DC-Ströme bekannt, bei dem ein Nebenschluss vorgesehen ist, um den Stoßstrom um die Kontakte herum abzuleiten und so die Lichtbogenbildung zu verringern. Der Nebenschluss umfasst einen Halbleiterschalter, der während der Bewegung der Kontakte in einer Reihe von Impulsen betrieben werden kann. Die Impulssteuerungseinheit kann ein Potenzial für Lichtbogenbildung erkennen und dann für einen periodisch pulsierenden Betrieb des Nebenschlusses sorgen.

Aufgabe der vorliegenden Erfindung ist es, eine Schaltvorrichtung zum Führen und Trennen von elektrischen Strömen, insbesondere eine Hybridschaltanordnung zum Führen und Trennen hoher DC-Ströme und niederfrequenter AC-Ströme, und ein Schaltgerät mit einer derartigen Schaltvorrichtung vorzuschlagen, bei denen die Gefahr des Ausbildens ungewollter Schaltlichtbögen reduziert ist und dadurch eine erhöhte Funktionssicherheit sowie eine möglichst hohe elektrische Lebensdauer erzielt werden kann.

Diese Aufgabe wird durch die Gegenstände der unabhängigen Ansprüche gelöst. Weitere Ausgestaltungen der Erfindung sind Gegenstand der abhängigen Ansprüche.

Eine genauere Untersuchung der Ursachen für die ungewollten Schaltlichtbögen bei den eingangs geschilderten und aus den deutschen Offenlegungsschriften DE 10 2013 114 259 A1 und DE 10 2013 114 260 A1 bekannten Schaltvorrichtungen, die zwei in Reihe geschaltete mechanische Kontaktanordnungen und einen parallel zu einer der mechanischen Kontaktanordnungen parallel geschalteten Halbleiterschalter aufweisen, durch die Erfinder hat gezeigt, dass die Gefahr von Schaltlichtbögen durch eine gezielte steuerungstechnische Modifikation des Ausschaltvorgangs reduziert werden kann. Daher schlägt die vorliegenden Erfindung vor, eine Schaltelektronik zum An- und Abschalten des Halbleiterschalters derart auszubilden, dass sie den Halbleiterschalter gemäß einer vorgegebenen Abfolge während eines Öffnungsvorgangs der ersten und zweiten mechanischen Kontaktanordnung zum Trennen von elektrischen Strömen mehrmals an- und wieder abschaltet. Durch das mindestens zweimalige Anschalten des Halbleiterschalters kann ein ungewollter Schaltlichtbogen durch Kommutierung seines elektrischen Stromes auf den Halbleiterschalter gelöscht werden, der sich beispielsweise nach der ersten Anschaltphase des Halbleiterschalters durch eine Rekontaktierung der Kontakte der mechanischen Kontaktanordnungen ausbildet.

Eine Ausführungsform der Erfindung betrifft nun eine Schaltvorrichtung zum Führen und Trennen von elektrischen Strömen mit einer ersten mechanischen Kontaktanordnung, einem Halbleiterschalter, der parallel zur ersten mechanischen Kontaktanordnung geschaltet ist, einer zweiten mechanischen Kontaktanordnung, die in Reihe zur ersten mechanischen Kontaktanordnung geschaltet ist, einer Hilfsspule, die galvanisch vom Stromkreis eines Schaltantriebs zum Bewegen von Kontakten der ersten und zweiten mechanischen Kontaktanordnung getrennt und mit einer Spule des Schaltantriebs elektromagnetisch derart gekoppelt ist, dass in ihr beim Abschalten der Spannungsversorgung des Schaltantriebs eine Spannung erzeugt wird, und einer Schaltelektronik, die zum An- und Abschalten des Halbleiterschalters ausgebildet ist und von der in der Hilfsspule beim Abschalten der Spannungsversorgung des Schaltantriebs erzeugten Spannung versorgt wird. Erfindungsgemäß ist die Schaltelektronik ausgebildet, den Halbleiterschalter gemäß einer vorgegebenen Abfolge während eines Öffnungsvorgangs der ersten und zweiten mechanischen Kontaktanordnung zum Trennen von elektrischen Strömen mehrmals an- und wieder abzuschalten.

Die vorgegebene Abfolge weist folgende zeitlich aufeinanderfolgende Schritte auf: erstes Anschalten des Halbleiterschalters, sobald die Schaltelektronik mit einer Spannung von der Hilfsspule versorgt wird, erstes Abschalten des Halbleiterschalters, zweites Anschalten des Halbleiterschalters nach Ablauf einer vorgegebenen Abschaltzeit und zweites Abschalten des Halbleiterschalters nach Ablauf einer vorgegebenen Stromleitzeit.

Es ist auch ein Stromwandler zum Erfassen des Stromflusses durch den Halbleiterschalter und Erzeugen eines entsprechenden Signals, wenn der Stromfluss von der ersten mechanischen Kontaktanordnung auf den Halbleiterschalter kommutiert, vorgesehen, wobei das Signal der Schaltelektronik zugeführt wird, und der Schritt des ersten Abschaltens des Halbleiterschalters weist folgende Schritte auf: falls die maximale Ansteuerzeit des Halbleiterschalters erreicht ist, Abschalten des Halbleiterschalters und falls die maximale Ansteuerzeit des Halbleiterschalters nicht erreicht ist und falls der Stromfluss von der ersten mechanischen Kontaktanordnung auf den Halbleiterschalter kommutiert hat, Abschalten des Halbleiterschalters nach Ablauf einer weiteren vorgegebenen Stromleitzeit nach Empfang des Signals vom Stromwandler.

Die weitere vorgegebene Stromleitzeit kann derart bemessen sein, dass sie etwa einer Zeitdauer zum Öffnen der Kontakte der ersten und zweiten mechanischen Kontaktanordnung entspricht.

Die vorgegebene Stromleitzeit kann derart bemessen sein, dass sie etwa einer Zeitdauer entspricht, bis ein elektrischer Strom aufgrund eines sich gegebenenfalls zwischen den geöffneten Kontakten der ersten und zweiten mechanischen Kontaktanordnung während des Öffnungsvorgangs ausgebildeten Lichtbogens auf den Halbleiterschalter kommutieren kann.

Insbesondere kann die Schaltelektronik ausgebildet sein, den Halbleiterschalter zum zweiten Mal nach einer Zeitdauer anzuschalten, die derart bemessen ist, dass durch den Öffnungsvorgang die erste und zweite mechanische Kontaktanordnung vollständig geöffnet sind.

Eine weitere Ausführungsform der Erfindung betrifft außerdem ein Schaltgerät mit einer Schaltvorrichtung nach der Erfindung und wie hierin beschrieben und einem Schaltantrieb zum Bewegen von Kontakten der ersten und zweiten mechanischen Kontaktanordnung. Ein solches Schaltgerät kann insbesondere einen speziell modifizierten Magnetantrieb besitzen, bei dem eine Hilfsspule einer Schaltvorrichtung gemäß der Erfindung um die Antriebsspule gewickelt ist und eine Schaltelektronik versorgt, die einen Hybridschalter des Schaltgeräts ansteuert.

Eine weitere Ausführungsform der Erfindung betrifft ein Verfahren zum Steuern eines Halbleiterschalters einer Schaltvorrichtung zum Führen und Trennen von elektrischen Strömen, die eine erste mechanische Kontaktanordnung, den Halbleiterschalter, der parallel zur ersten mechanischen Kontaktanordnung geschaltet ist, eine zweite mechanische Kontaktanordnung, die in Reihe zur ersten mechanischen Kontaktanordnung geschaltet ist, wobei bei dem Verfahren der Halbleiterschalter gemäß einer vorgegebenen Abfolge während eines Öffnungsvorgangs der ersten und zweiten mechanischen Kontaktanordnung zum Trennen von elektrischen Strömen mehrmals an- und wieder abgeschaltet wird.

Verfahrensgemäß weist die vorgegebene Abfolge folgende zeitlich aufeinanderfolgende Schritte auf: erstes Anschalten des Halbleiterschalters, sobald der Öffnungsvorgang eingeleitet wird, erstes Abschalten des Halbleiterschalters, zweites Anschalten des Halbleiterschalters nach Ablauf einer vorgegebenen Abschaltzeit und zweites Abschalten des Halbleiterschalters nach Ablauf einer vorgegebenen Stromleitzeit.

Verfahrensgemäß ist ein Stromwandler zum Erfassen des Stromflusses durch den Halbleiterschalter und Erzeugen eines entsprechenden Signals, wenn der Stromfluss von der ersten mechanischen Kontaktanordnung auf den Halbleiterschalter kommutiert, vorgesehen, wobei das Signal der Schaltelektronik zugeführt wird, und der Schritt des ersten Abschaltens des Halbleiterschalters weist folgende Schritte auf: falls die maximale Ansteuerzeit des Halbleiterschalters erreicht ist, Abschalten des Halbleiterschalters und falls die maximale Ansteuerzeit des Halbleiterschalters nicht erreicht ist und falls der Stromfluss von der ersten mechanischen Kontaktanordnung auf den Halbleiterschalter kommutiert hat, Abschalten des Halbleiterschalters nach Ablauf einer weiteren vorgegebenen Stromleitzeit nach Empfang des Signals vom Stromwandler.

Das Verfahren kann von einer zum An- und Abschalten des Halbleiterschalters ausgebildeten Schaltelektronik ausgeführt werden. Insbesondere kann die Schaltelektronik durch einen Prozessor und einen Speicher implementiert sein, in dem ein Programm gespeichert ist, das den Prozessor zum Ausführen eines Verfahrens nach der Erfindung und wie hierin beschrieben konfiguriert.

Weitere Vorteile und Anwendungsmöglichkeiten der vorliegenden Erfindung ergeben sich aus der nachfolgenden Beschreibung in Verbindung mit den in den Zeichnungen dargestellten Ausführungsbeispielen.

In der Beschreibung, in den Ansprüchen, in der Zusammenfassung und in den Zeichnungen werden die in der hinten angeführten Liste der Bezugszeichen verwendeten Begriffe und zugeordneten Bezugszeichen verwendet.

Die Zeichnungen zeigen in
Fig. 1 ein Blockschaltbild eines Ausführungsbeispiels einer Schaltvorrichtung mit einer Doppelkontaktanordnung gemäß der Erfindung; und
Fig. 2a-2c ein beispielhafter Bewegungsablauf beim Öffnen der Kontakte einer Doppelkontaktanordnung; und
Fig. 3 ein Ablaufdiagramm der Steuerung eines Halbleiterschalters durch eine Schaltelektronik einer Schaltvorrichtung gemäß der Erfindung.

In der folgenden Beschreibung können gleiche, funktional gleiche und funktional zusammenhängende Elemente mit den gleichen Bezugszeichen versehen sein. Absolute Werte sind im Folgenden nur beispielhaft angegeben und sind nicht als die Erfindung einschränkend zu verstehen.

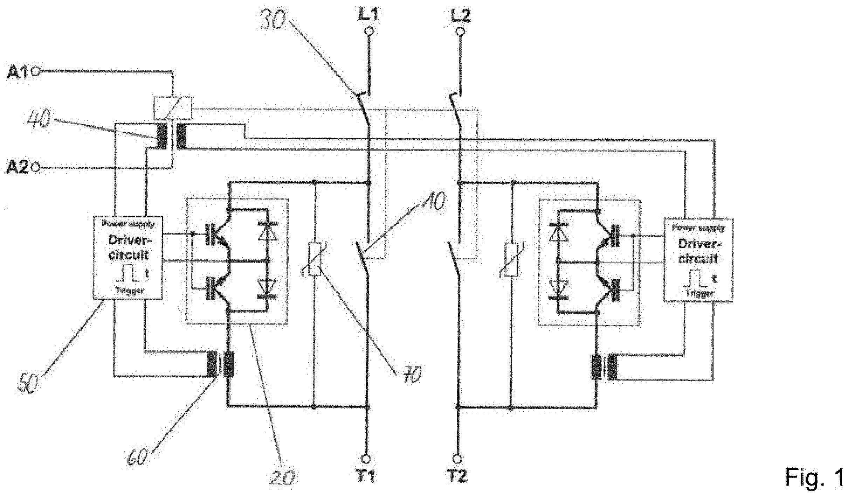

Fig. 1 zeigt das Blockschaltbild einer erfindungsgemäßen Schaltvorrichtung für ein 2-poliges, polaritätsunabhängiges Schaltgerät. Die Anschlüsse des Schaltgeräts für die beiden Pole sind jeweils mit L1, T1 und L2, T2 bezeichnet. Diese Schaltvorrichtung entspricht schaltungstechnisch weitgehend der in der deutschen Offenlegungsschrift DE 10 2013 114 259 A1 beschriebenen und darin in Fig. 1 gezeigten Vorrichtung. Von dieser bekannten Vorrichtung unterscheidet sich die nachfolgend beschriebene erfinderische Vorrichtung in der Schaltelektronik 50, die für eine spezielle Ansteuerung des Halbleiterschalters 20 ausgebildet ist, wie in der nachfolgenden Beschreibung noch im Detail erläutert wird. Die Schaltelektronik 50 kann beispielsweise durch einen Prozessor und einen Speicher implementiert sein (insbesondere einen Mikrokontroller), wobei in dem Speicher ein Programm gespeichert ist, das den Prozessor zum Ausführen von Verfahrensschritten konfiguriert, welche die spezielle Ansteuerung des Halbleiterschalters 20 wie nachfolgend beispielhaft erläutert durch den Prozessor bewirken. Das Programm kann beispielsweise Teil der Firmware eines Prozessor-gesteuerten Schaltgeräts sein.

Für jeden Pol weist die in Fig. 1 gezeigte Schaltvorrichtung eine Parallelschaltung einer ersten mechanischen (Lösch-)Kontaktanordnung 10 mit einem Halbleiterschalter 20 auf Basis einer antiseriellen IGBT-Anordnung (Leistungshalbleiter) auf, welche mit einer zweiten mechanischen Kontaktanordnung 30 zur Sicherstellung der galvanischen Trennung in Serie geschaltet ist. Die mechanischen Kontaktanordnungen 10 und 30 können als Brückenschaltanordnung eines Luftschaltgeräts bzw. -anordnung ausgebildet sein.

Der Halbleiterschalter 20 wird von der Schaltelektronik 50 an- oder abgeschaltet, d.h. durchgesteuert oder gesperrt. Die Schaltelektronik 50 wird von einer in der (Magnetantriebs-)Spule des Schalt- bzw. Magnetantriebs des Schaltgeräts gespeicherten Energie versorgt. Hierzu ist eine galvanisch vom Stromkreis des Schaltantriebs getrennte Hilfsspule 40 vorgesehen, welche beim Abschalten des Schaltantriebs eine Spannung zum Versorgen der Schaltelektronik 50 erzeugen kann. Die Hilfsspule 40 kann beispielsweise um die Antriebsspule gewickelt sein.

Im eingeschalteten Fall, d.h. wenn der Schaltantrieb die Magnetantriebs-Spule mit einer Spannung und einem Strom versorgt und die Kontakte der ersten und zweiten mechanischen Kontaktanordnungen 10 und 30 geschlossen sind, ist der Halbleiterschalter 20 gesperrt, da in diesem Zustand von der Hilfsspule 40 keine Spannung zum Versorgen der Schaltelektronik 50 erzeugt wird und die Schaltelektronik 50 daher spannungslos ist und die IGBTs des Halbleiterschalters 20 nicht ansteuern kann.

Im Moment des Abschaltens der Spannungs- und Stromversorgung der Magnetantriebs-Spule des Schaltantriebs zum Öffnen der Kontakte der ersten und zweiten mechanischen Kontaktanordnungen 10 und 30 erzeugt die in der Magnetantriebs-Spule gespeicherte Energie eine Freilaufspannung, die wiederum in der elektromagnetisch mit der Magnetantriebs-Spule gekoppelten Hilfsspule 40 eine Spannung induziert, welche die Schaltelektronik 50 aktiviert.

Die in der Hilfsspule 40 induzierte Spannung reicht aus, um zum einen die Schaltelektronik 50 selbst zu versorgen, zum anderen um die zum Ansteuern der IGBTs erforderliche Spannung aufzubauen. Die Hilfsspule 40 bietet den Vorteil, dass die Ansteuerung des Halbleiterschalters bereits vor Öffnung der Kontakte der ersten und zweiten mechanischen Kontaktanordnungen 10 bzw. 30 erfolgen kann.

Bei Schaltgeräten mit elektromechanischem Magnetantrieb beträgt der Zeitraum zwischen Initiierung des Abschaltvorgangs und dem Öffnen der mechanischen Kontakte in der Regel mehrere Millisekunden (ms), typischerweise rd. 10 ms. In dieser Zeit ist der Schwellwert der IGBT-Ansteuerspannung (typischerweise im Bereich 6 - 7V) durch die in der Hilfsspule 40 induzierte Spannung bereits überschritten, so dass die Schaltelektronik 50 diese auf die IGBTs des Halbleiterschalters 20 durchschalten kann, wodurch die IGBTs niederohmig geschaltet werden (der Halbleiterschalter 20 also angeschaltet wird) und der zu schaltende Laststrom mit dem Öffnen der (Lösch-)Kontakte der ersten mechanischen Kontaktanordnung 10 sofort auf den Halbleiterschalter 20 kommutiert.

Durch die vorauseilende Ansteuerung der IGBTs bildet sich zwischen den sich öffnenden Lösch-Kontakten der ersten mechanischen Kontaktanordnung 10 somit in der Regel kein Lichtbogen mehr aus.

Die Trenn-Kontakte der zweiten mechanischen Kontaktanordnung 30 öffnen-nicht zeitgleich mit den Lösch-Kontakten der ersten mechanischen Kontaktanordnung 10, sondern die Öffnung der Trenn-Kontakte soll mit einer definierten zeitlichen Verzögerung gegenüber den Lösch-Kontakten erfolgen, was beispielsweise durch eine entsprechende mechanische Ausgestaltung der beiden mechanischen Kontaktanordnungen 10 und 30 bewerkstelligt werden kann.

Idealerweise erfolgt dabei das verzögerte Öffnen dieser beiden mechanischen Kontaktanordnungen 10 und 30 in einem zeitlichen Abstand, welcher größer ist als die Stromflußzeit durch den Halbleiterschalter 20, wodurch sich die Ausbildung eines Schaltlichtbogens zwischen den Kontakten völlig vermeiden lässt. In der Praxis ist dieses zeitlich verzögerte Öffnen der Kontakte jedoch nicht oder nur mit einem größeren Aufwand erreichbar, so dass ein kurzzeitiges Brennen eines Schaltlichtbogens über den Kontakten bis zum Erlöschen des durch den Halbleiterschalter fließenden Stroms auftritt.

Wie eine Untersuchung der Erfinder ergab, kann bei häufigem Schalten von DC-Strömen, insbesondere bei gleicher Polarität, durch diese wiederkehrende Lichtbogenbeanspruchung bei einem Luftschaltgerät wie dem vorstehend beschriebenen sich allmählich die Topografie der Kontaktoberfläche verändern, v.a. in der Weise, dass es aufgrund der bekanntermaßen deutlich unterschiedlichen Mobilität sowie der kinetischen Energie von Kationen und Anionen in der Schaltstrecke zu einer Materialwanderung mit sich kontinuierlichen verändernden Kontaktoberflächen kommt.

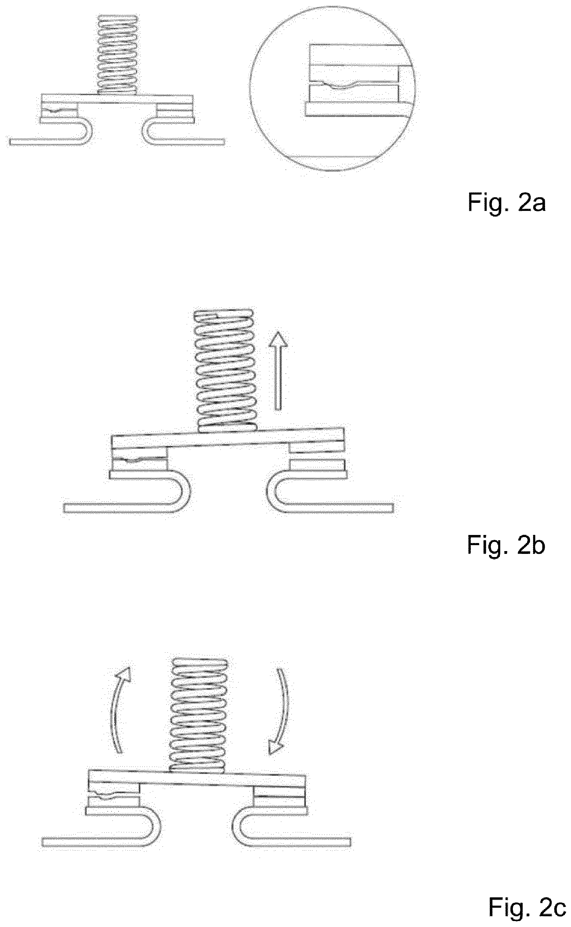

Beim Einschalten von DC-Strömen im Bereich mehrerer hundert Ampere steigt bei hohen Schaltzahlen auf solchen Kontaktoberflächen die Neigung zu meist leichten, häufig auch "Verpappungen" genannten punktuellen Verschweißungen. Beim Ausschaltvorgang kann es dann passieren, dass sich zunächst die Löschkontakte geringfügig öffnen, während die Trennkontakte aufgrund der Verschweißung noch geschlossen sind. Dabei kommt es routinemäßig zur Kommutierung des Laststroms auf den durchgesteuerten Leistungshalbleiter, wo er nach kurzer Zeit zu Null geführt wird. Beim weiteren Öffnen der Schaltbrücke wird dann die Verschweißung der Trennkontakte durch den Schaltantrieb in der Regel aufgebrochen. Dabei kann es unter Einwirkung der Kontaktdruckfeder zu einer Kippbewegung der Schaltbrücke kommen, was bei den noch geringen Kontaktabständen die Gefahr einer kurzzeitigen Rekontaktierung birgt. Ein solcher Bewegungsablauf bei einer Schaltbrücke ist in den Fig. 2a - 2c schematisch dargestellt (Fig. 2a: geschlossene DC-Kontaktbrücke mit einseitiger Verschweißung aufgrund fortgeschrittener Materialwanderung; Fig. 2b: Beginn der Kontaktöffnung bei einseitiger Verschweißung; Fig. 2c: Rekontaktierung nach Aufbruch der Kontaktverschweißung). Beim Fortführen des Kontaktöffnungsvorgangs kann es dann zur Ausbildung von Lichtbögen kommen. Da nach dem Abschluss des unmittelbar vorausgegangenen Löschvorgangs der Leistungshalbleiter nicht mehr durchgeschaltet ist, kommt nach der beschriebenen Rekontaktierung beim zweiten, endgültigen Öffnen der Löschkontakte in der Regel eine erneute Kommutierung auf den Halbleiter nicht mehr zustande. Im Ergebnis kann sich in solchen Fällen mit dem endgültigen Öffnen der Löschkontakte ungewollt ein dauerhafter DC-Lichtbogen ausbilden, welcher zur Zerstörung des Schaltgeräts führt.

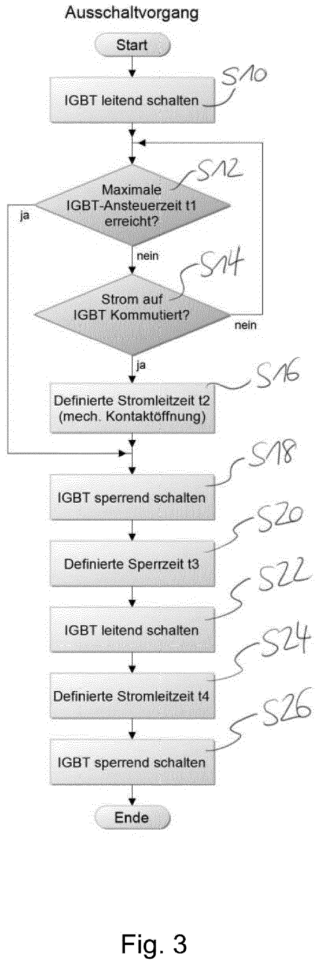

Auch bei der in der deutschen Offenlegungsschrift DE 10 2013 114 260 A1 in Fig. 3 gezeigten Vakuumschaltanordnung zum Führen und Trennen sehr hoher Ströme, die zwei getrennte Vakuumkammern mit voneinander unabhängigen Kontaktanordnungen aufweist, welche elektrisch als Serienschaltung ausgeführt und in einem einzigen Baukörper zusammengefasst sind, kann es unter bestimmten Bedingungen zu ungewollten Lichtbögen kommen, wie eine Untersuchung der Erfinder ergab.

Gemäß dem Wirkprinzip dieses Doppelkontaktschalters öffnet beim Ausschaltvorgang zunächst eine der beiden Kontaktpaare durch die Öffnungsbewegung der beweglichen Elektrode, welche mechanisch fest mit dem Schaltantrieb verbunden ist. Wie im Fall der oben beschriebenen Brückenschaltanordnung erfolgt im Moment des Kontaktöffnens eine Kommutierung des Laststroms wieder auf einen parallel geschalteten Leistungshalbleiter, in dem der Laststrom in kurzer Zeit zu Null geführt wird. Über das zweite Kontaktpaar, welches vorzugsweise mit einer leichten Zeitverzögerung öffnet, wird anschließend die galvanische Trennung im Hybridschalter sichergestellt. Die Öffnung dieses Trennkontaktpaars erfolgt in der Weise, dass über die erstöffnende bewegliche Elektrode eine Zugkraft auf die Vakuumschaltröhre ausgeübt wird, wodurch sich diese in Richtung der ziehenden Elektrode bewegt, bis sie einen mechanischen Anschlag erreicht. Dadurch, dass die zweite bewegliche Elektrode mit dem Gehäuse des Hybridschalters fest verbunden ist, wird durch die Bewegung der Vakuumröhre das Öffnen des zweiten Kontaktpaars bewirkt; bei Erreichen des Anschlags ist die gewünschte Trennstrecke zwischen den beiden Kontakten erreicht.

Wenn die bewegliche Elektrode der Löschkontaktanordnung ihre Endposition im Schaltgerät erreicht hat, kommt es aufgrund der Massenträgheit der bewegten Schaltanordnung häufig zu einem Rückprellen. Da bei Niederspannungsschaltgeräten die Kontaktöffnungsstrecken von Vakuumschaltkammern meist nur 1 - 2 mm betragen, kann es in ungünstigen Fällen durch den Rückprellvorgang zu einer kurzzeitigen Rekontaktierung der Löschkontakte kommen. Wenn der Leistungshalbleiter in diesem Moment nicht mehr durchgeschaltet ist, kann es beim anschließenden endgültigen Öffnen der Löschkontakte zur Ausbildung eines dauerhaften Vakuumlichtbogens kommen, welcher wie im ersten beschriebenen Fall zur Zerstörung des Schaltgeräts führt.

Um die Gefahr dieser ungewollten Lichtbogenausbildung insbesondere durch Rekontaktierung (beispielsweise aufgrund von Kippbewegungen einer Schaltbrücke oder aufgrund von Rückprellen) zu verringern, ist die Schaltelektronik 50 erfindungsgemäß derart ausgebildet, dass sie den Halbleiterschalter 20 gemäß einer vorgegebenen Abfolge während eines Öffnungsvorgangs der mechanischen Kontaktanordnungen 10, 30 mehrmals an- und wieder abschaltet. Durch mindestens ein weiteres Anschalten des Halbleiterschalters 20 kann ein ungewollter Lichtbogen, insbesondere verursacht durch Rekontaktierung nach bereits erfolgter Öffnung der Kontakte, durch Kommutierung seines elektrischen Stromes auf die IGBTs des angeschalteten Halbleiterschalters 20 (die IGBTs sind niederohmig geschaltet) zum Verlöschen gebracht werden.

Die vorgegebene Abfolge zum An- und Abschalten des Halbleiterschalters 20 kann auf verschiedene Arten implementiert werden, wie nachfolgend erläutert wird.

Grundsätzlich ist es möglich, dass die Schaltelektronik eine fest vorgegebene Abfolge des An- und Abschaltens implementiert, bei der die verschiedenen An- und Abschaltphasen (bzw. Stromleit- und Abschaltzeiten des Halbleiterschalters 20 bzw. seiner IGBTs) an die mechanischen Parameter der Kontaktanordnung der jeweiligen Schaltvorrichtung angepasst sein können und elektronische Parameter wie beispielsweise die Strombelastbarkeit des Halbleiterschalters 20 berücksichtigt werden können.

Eine beispielhafte vorgegebene Abfolge kann folgende zeitlich aufeinanderfolgende Schritte aufweisen, die von der Schaltelektronik 50 ausgeführt werden, um den Halbleiterschalter 20 entsprechend anzusteuern (unter Bezugnahme auf das in Fig. 3 gezeigte Ablaufdiagramm einer beispielhaften Ansteuerung des Halbleiterschalters 20 durch die Schaltelektronik 50):
Durch die in der elektromagnetisch mit der Magnetantriebs-Spule gekoppelten Hilfsspule 40 beim Abschalten der Spannungs- und Stromversorgung der Magnetantriebs-Spule des Schaltantriebs zum Öffnen der Kontakte der ersten und zweiten mechanischen Kontaktanordnungen 10 und 30 induzierte Spannung wird die Schaltelektronik 50 aktiviert und baut die zum Ansteuern der IGBTs erforderliche Spannung auf, so dass die IGBTs des Halbleiterschalters 20 niederohmig geschaltet werden (der Halbleiterschalter 20 also angeschaltet wird = erstes Anschalten des Halbleiterschalters, Schritt S10), was eine Kommutierung des zu schaltenden Laststrom mit dem Öffnen der (Lösch-)Kontakte der ersten mechanischen Kontaktanordnung 10 auf den Halbleiterschalter 20 bewirkt.

Anschließend schaltet die Schaltelektronik 50 den Halbleiterschalter 20 wieder ab (Schritt S18), indem sie die zum Ansteuern der IGBTs erforderliche Spannung soweit reduziert, dass die IGBTs des Halbleiterschalters 20 hochohmig geschaltet werden, also für einen nennenswerten Stromfluss gesperrt sind. Erfindungsgemäß erfolgt diese Abschaltung nach einer Zeitdauer, die entsprechend dem Strombelastbarkeit der IGBTs nämlich der maximalen Ansteuerzeit des Halbleiterschalters 20 (Schritt S12) und/oder der benötigten Zeitdauer zum vollständigen Öffnen der Kontakte bemessen ist. Nachdem eine vorgegebene Abschaltzeit abgelaufen ist (Schritt S20), schaltet die Schaltelektronik 50 den Halbleiterschalter 20 wieder an (Schritt S22), indem sie die zum Ansteuern der IGBTs erforderliche Spannung soweit erhöht, dass die IGBTs des Halbleiterschalters 20 erneut niederohmig geschaltet werden. Dadurch kann ein gegebenenfalls über einen Lichtbogen zwischen Kontakten fließender Strom auf die IGBTs des Halbleiterschalters 20 kommutieren, so dass der Lichtbogen verlöscht.

Nach Ablauf einer vorgegebenen Stromleitzeit (Schritt S24) schaltet die Schaltelektronik 50 den Halbleiterschalter 50 wieder ab (Schritt S26), indem sie wieder die zum Ansteuern der IGBTs erforderliche Spannung soweit reduziert, dass die IGBTs des Halbleiterschalters 20 hochohmig geschaltet werden und sperren. Nun kann der Halbleiterschalter 20 endgültig abgeschaltet bleiben, bis die Kontakte erneut betätigt werden sollen. Es können aber prinzipiell weitere An- und Abschaltvorgänge durch die Schaltelektronik 50 initiiert werden, abhängig von den Anforderungen der Schaltvorrichtung, insbesondere deren mechanischen Kontaktapparat und die Gefahr der Ausbildung von Lichtbögen.

Im Hinblick auf eine möglichst hohe elektrische Lebensdauer der IGBTs sowie auf deren vertretbar große Dimensionierung ist es zweckmäßig, den Stromfluss durch den Halbleiterschalter 20 zeitlich in der Weise zu begrenzen, dass der Strom dort nur so lange fließt, bis die mechanische Schaltstrecke eine ausreichende Wiederverfestigung erreicht hat. Für die Minimierung der Stromflusszeit durch den Halbleiterschalter 20 ist die genaue Kenntnis des Kommutierungszeitpunkts wichtig, da bei jedem Schaltgerät die effektiven Zeiten für den mechanischen Abschaltvorgang aus verschiedenen Gründen schwanken.

Der Zeitpunkt der Kommutierung auf den bereits durchgesteuerten IGBT des Halbleiterschalters 20 kann durch einen dort befindlichen Stromwandler 60 erfasst werden. Der Stromwandler 60 erzeugt ein Signal, sobald durch die IGBTs des Halbleiterschalters 20 ein Strom zu fließen beginnt, der Stromfluss also von der ersten mechanischen Kontaktanordnung 10 auf den Halbleiterschalter 20 kommutiert (Schritt S14). Das vom Stromwandler 60 erzeugte und die Kommutierung signalisierende Signal wird der Schaltelektronik 50 zugeführt, die davon abhängig den Halbleiterschalter 20 wie im Folgenden beschrieben ansteuern kann.

Unmittelbar nach erfolgter Kommutierung kann die Schaltelektronik 50 den Halbleiterschalter 20 in der Weise ansteuern, dass die IGBTs des Halbleiterschalters 20 nach kurzer, über die Ansteuerelektronik definierter bzw. vorgegebener Stromflusszeit bzw. Stromleitzeit (Schritt S16) wieder sperrend werden (Schritt S18), so dass der kommutierte Laststrom im Halbleiterschalter 20 innerhalb der definierten Zeitdauer zu null geführt wird. Die Stromflusszeit kann dabei über die Schaltelektronik 50 so bemessen sein, dass bei Ausbildung eines kurzzeitigen Schaltlichtbogens an den Trenn-Kontakten nach dessen Verlöschung eine ausreichende Zeit zur Wiederverfestigung der Schaltstrecke besteht. Dies ist vor allem bei Luftschaltstrecken für hohe Ströme wichtig. Bei Verwendung von Vakuumschaltkammern für die mechanische Trennung lassen sich vergleichbar kurze Wiederverfestigungszeiten erzielen, was für die Minimierung der Stromflusszeit in den IGBTs von Vorteil ist.

Durch die Ausstattung des Halbleiterschalters 20 mit einem antiseriellen IGBT ist eine solche Schaltanordnung sowohl für DC-Ströme mit beliebiger Stromflussrichtung als auch für Wechselspannungen unterschiedlicher Frequenz einsetzbar, wobei der Schaltzeitpunkt aufgrund der unabhängigen Versorgung des Ansteuermoduls nicht phasenwinkelabhängig ist.

Während des Abschaltvorgangs im Halbleiterschalter 20 kommt es bei hohen Strömen zu hohen dl/dt-Werten, wodurch Spannungsspitzen deutlich oberhalb 1 kV entstehen können. Zum Schutz vor solchen Spannungsspitzen ist es zweckmäßig, dem Halbleiterschalter 20 ein Schutzorgan, z.B. in Form eines Varistors 70 vorzuschalten oder parallel zu schalten.

Mit dem Erreichen des Strom-Null-Zustands wird der Halbleiterschalter 20 dauerhaft sperrend. Durch die inzwischen geöffneten Trenn-Kontakte 30 wird im HybridSchalter gleichzeitig eine sichere galvanische Trennung hergestellt.

Wenn man über eine geeignete mechanische Kopplung oder auch auf elektronischem Weg dafür sorgt, dass die Lösch-Kontakte der ersten mechanischen Kontaktanordnung 20 den Trenn-Kontakten der zweiten mechanischen Kontaktanordnung 30 um die Zeit vorauseilen, in der der Halbleiterschalter 20 durchlässig ist, lässt sich erreichen, dass beide mechanischen Kontaktanordnungen 10 und 30 nahezu völlig lichtbogenfrei schalten, was für die Lebenserwartung der Schaltvorrichtung und insbesondere des Hybrid-Schalters von entsprechendem Vorteil ist.

Die vorliegende Erfindung eignet sich insbesondere zum Einsatz in Schützen, Leistungsschaltern und Motorschutzschaltern, die insbesondere für einen Betrieb mit Gleichströmen und/oder niederfrequenten Strömen ausgelegt sind. Sie ermöglicht das Schalten von hohen Gleichströmen und niederfrequenten Strömen bei einer vergleichsweise hohen elektrischen Lebensdauer, da lange Lichtbogenbrenndauern ebenso wie eine lange Strombelastung des Halbleiterschalters vermieden werden können. Weiterhin gestatten diese Eigenschaften die Realisierung von vergleichsweise kompakten Schaltgeräten für hohe Ströme.

### Bezugszeichen

- 10: erste mechanische Kontaktanordnung
- 20: Halbleiterschalter
- 30: zweite mechanische Kontaktanordnung
- 40: galvanisch getrennte Hilfsspule
- 50: Schaltelektronik
- 60: Stromwandler
- 70: Varistor

## Patentansprüche

1. Schaltvorrichtung zum Führen und Trennen von elektrischen Strömen mit
- einer ersten mechanischen Kontaktanordnung (10),
- einem Halbleiterschalter (20), der parallel zur ersten mechanischen Kontaktanordnung geschaltet ist,
- einer zweiten mechanischen Kontaktanordnung (30), die in Reihe zur ersten mechanischen Kontaktanordnung geschaltet ist,
- einer Hilfsspule (40), die galvanisch vom Stromkreis eines Schaltantriebs zum Bewegen von Kontakten der ersten und zweiten mechanischen Kontaktanordnung getrennt und mit einer Spule des Schaltantriebs elektromagnetisch derart gekoppelt ist, dass in ihr beim Abschalten der Spannungsversorgung des Schaltantriebs eine Spannung erzeugt wird, und
- einer Schaltelektronik (50), die zum An- und Abschalten des Halbleiterschalters (20) ausgebildet ist und von der in der Hilfsspule beim Abschalten der Spannungsversorgung des Schaltantriebs erzeugten Spannung versorgt wird,
**dadurch gekennzeichnet, dass**
die Schaltelektronik (50) ausgebildet ist, den Halbleiterschalter (20) gemäß einer vorgegebenen Abfolge während eines Öffnungsvorgangs der ersten und zweiten mechanischen Kontaktanordnung (10, 30) zum Trennen von elektrischen Strömen mehrmals an- und wieder abzuschalten,
wobei die vorgegebene Abfolge folgende zeitlich aufeinanderfolgende Schritte aufweist:
- erstes Anschalten des Halbleiterschalters (S10), sobald die Schaltelektronik mit einer Spannung von der Hilfsspule versorgt wird,
- erstes Abschalten des Halbleiterschalters (S12, S14, S16, S18),
- zweites Anschalten des Halbleiterschalters nach Ablauf einer vorgegebenen Abschaltzeit (S20, S22) und
- zweites Abschalten des Halbleiterschalters nach Ablauf einer vorgegebenen Stromleitzeit (S24, S26),
und wobei ein Stromwandler (60) zum Erfassen des Stromflusses durch den Halbleiterschalter und Erzeugen eines entsprechenden Signals, wenn der Stromfluss von der ersten mechanischen Kontaktanordnung (10) auf den Halbleiterschalter (20) kommutiert, vorgesehen ist, wobei das Signal der Schaltelektronik zugeführt wird, und
der Schritt des ersten Abschaltens des Halbleiterschalters folgende Schritte aufweist:
falls die maximale Ansteuerzeit (t1) des Halbleiterschalters (20) erreicht ist (S12, "ja"), Abschalten (S18) des Halbleiterschalters (20) und falls die maximale Ansteuerzeit (t1) des Halbleiterschalters (20) nicht erreicht ist (S12, "nein") und falls der Stromfluss von der ersten mechanischen Kontaktanordnung (10) auf den Halbleiterschalter (20) kommutiert hat (S14, "ja"), Abschalten (S18) des Halbleiterschalters (20) nach Ablauf einer weiteren vorgegebenen Stromleitzeit (t2) nach Empfang des Signals vom Stromwandler (S16).

2. Schaltvorrichtung nach Anspruch 1,
**dadurch gekennzeichnet, dass**
die weitere vorgegebene Stromleitzeit derart bemessen ist, dass sie etwa einer Zeitdauer zum Öffnen der Kontakte der ersten und zweiten mechanischen Kontaktanordnung entspricht.

3. Schaltvorrichtung nach Anspruch 1 oder 2,
**dadurch gekennzeichnet, dass**
die vorgegebene Stromleitzeit derart bemessen ist, dass sie etwa einer Zeitdauer entspricht, bis ein elektrischer Strom aufgrund eines sich gegebenenfalls zwischen den geöffneten Kontakten der ersten und zweiten mechanischen Kontaktanordnung während des Öffnungsvorgangs ausgebildeten Lichtbogens auf den Halbleiterschalter kommutieren kann.

4. Schaltvorrichtung nach einem der vorhergehenden Ansprüche,
**dadurch gekennzeichnet, dass**
die Schaltelektronik ausgebildet ist, den Halbleiterschalter zum zweiten Mal nach einer Zeitdauer anzuschalten, die derart bemessen ist, dass durch den Öffnungsvorgang die erste und zweite mechanische Kontaktanordnung vollständig geöffnet sind.

5. Schaltgerät mit
- einer Schaltvorrichtung nach einem der vorhergehenden Ansprüche und
- einem Schaltantrieb zum Bewegen von Kontakten der ersten und zweiten mechanischen Kontaktanordnung.

6. Verfahren zum Steuern eines Halbleiterschalters (20) einer Schaltvorrichtung zum Führen und Trennen von elektrischen Strömen, die eine erste mechanische Kontaktanordnung (10), den Halbleiterschalter (20), der parallel zur ersten mechanischen Kontaktanordnung geschaltet ist, eine zweite mechanische Kontaktanordnung (30), die in Reihe zur ersten mechanischen Kontaktanordnung geschaltet ist, wobei bei dem Verfahren der Halbleiterschalter (20) gemäß einer vorgegebenen Abfolge während eines Öffnungsvorgangs der ersten und zweiten mechanischen Kontaktanordnung (10, 30) zum Trennen von elektrischen Strömen mehrmals an- und wieder abgeschaltet wird,
**dadurch gekennzeichnet, dass**
die vorgegebene Abfolge folgende zeitlich aufeinanderfolgende Schritte aufweist:
- erstes Anschalten des Halbleiterschalters (S10), sobald der Öffnungsvorgang eingeleitet wird,
- erstes Abschalten des Halbleiterschalters (S12, S14, S16, S18),
- zweites Anschalten des Halbleiterschalters nach Ablauf einer vorgegebenen Abschaltzeit (S20, S22) und
- zweites Abschalten des Halbleiterschalters nach Ablauf einer vorgegebenen Stromleitzeit (S24, S26)
und wobei ein Stromwandler (60) zum Erfassen des Stromflusses durch den Halbleiterschalter und Erzeugen eines entsprechenden Signals, wenn der Stromfluss von der ersten mechanischen Kontaktanordnung (10) auf den Halbleiterschalter (20) kommutiert, vorgesehen ist, wobei das Signal der Schaltelektronik zugeführt wird, und der Schritt des ersten Abschaltens des Halbleiterschalters folgende Schritte aufweist:
falls die maximale Ansteuerzeit (t1) des Halbleiterschalters (20) erreicht ist (S12, "ja"), Abschalten (S18) des Halbleiterschalters (20) und falls die maximale Ansteuerzeit (t1) des Halbleiterschalters (20) nicht erreicht ist (S12, "nein") und falls der Stromfluss von der ersten mechanischen Kontaktanordnung (10) auf den Halbleiterschalter (20) kommutiert hat (S14, "ja"), Abschalten (S18) des Halbleiterschalters (20) nach Ablauf einer weiteren vorgegebenen Stromleitzeit (t2) nach Empfang des Signals vom Stromwandler (S16).

7. Verfahren nach Anspruch 6, **dadurch gekennzeichnet, dass** es von einer zum An- und Abschalten des Halbleiterschalters (20) ausgebildeten Schaltelektronik (50) ausgeführt wird, wobei die Schaltelektronik (50) insbesondere durch einen Prozessor und einen Speicher implementiert ist, in dem ein Programm gespeichert ist, das den Prozessor zum Ausführen eines Verfahrens nach Anspruch 6 konfiguriert.

## Claims

1. Switching device for guiding and disconnecting electric currents, comprising
- a first mechanical contact arrangement (10),
- a semiconductor switch (20), which is connected in parallel with the first mechanical contact arrangement,
- a second mechanical contact arrangement (30), which is connected in series to the first mechanical contact arrangement,
- an auxiliary coil (40), which is galvanically isolated from the circuit of a switching drive for moving contacts of the first and the second mechanical contact arrangement and is electromagnetically coupled to a coil of the switching drive in such a way that a voltage is generated therein when the voltage supply of the switching drive is switched off, and
- a switching electronics system (50), which is designed to switch the semiconductor switch (20) on and off and which is supplied by the voltage generated in the auxiliary coil when the voltage supply of the switching drive is switched off,
**characterized in that**
the switching electronics system (50) is designed to switch the semiconductor switch (20) on and off again several times in accordance with a predetermined sequence during an opening process of the first and the second mechanical contact arrangement (10, 30) in order to disconnect electrical currents,
the predetermined sequence having the following temporally successive steps:
- first switching on of the semiconductor switch (S10) as soon as the switching electronics system is supplied with a voltage from the auxiliary coil,
- first switching off of the semiconductor switch (S12, S14, S16, S18),
- second switching on of the semiconductor switch after a predetermined switch-off time has elapsed (S20, S22) and
- second switching off of the semiconductor switch after a predetermined current guiding time has elapsed (S24, S26),
and a current transformer (60) being provided for detecting the current flow through the semiconductor switch and generating a corresponding signal when the current flow from the first mechanical contact arrangement (10) to the semiconductor switch (20) commutates, the signal being supplied to the switching electronics system, and the step of first switching off of the semiconductor switch having the following steps:
if the maximum actuation time (t1) of the semiconductor switch (20) is reached (S12, "yes"), switching off (S18) of the semiconductor switch (20), and if the maximum actuation time (t1) of the semiconductor switch (20) is not reached (S12, "no") and if the current flow from the first mechanical contact arrangement (10) to the semiconductor switch (20) has commutated (S14, "yes"), switching off (S18) of the semiconductor switch (20) after a further predetermined current guiding time (t2) has elapsed after the signal has been received from the current transformer (S16).

2. Switching device according to claim 1,
**characterized in that**
the further predetermined current guiding time is dimensioned such that it corresponds approximately to a time period for opening the contacts of the first and the second mechanical contact arrangement.

3. Switching device according to either claim 1 or claim 2,
**characterized in that**
the predetermined current guiding time is dimensioned such that it corresponds approximately to a time period until an electrical current can commutate on the semiconductor switch due to an arc possibly formed between the open contacts of the first and the second mechanical contact arrangement during the opening process.

4. Switching device according to any of the preceding claims,
**characterized in that**
the switching electronics system is designed to connect the semiconductor switch for the second time after a time period which is dimensioned such that the first and the second mechanical contact arrangement are completely opened by the opening process.

5. Switching apparatus having
- a switching device according to any of the preceding claims and
- a switching drive for moving contacts of the first and the second mechanical contact arrangement.

6. Method for controlling a semiconductor switch (20) of a switching device for guiding and disconnecting electrical currents, which a first mechanical contact arrangement (10), the semiconductor switch (20), which is connected in parallel with the first mechanical contact arrangement, a second mechanical contact arrangement (30), which is connected in series to the first mechanical contact arrangement, wherein in the method the semiconductor switch (20) is switched on and off several times in accordance with a predetermined sequence during an opening process of the first and the second mechanical contact arrangement (10, 30) in order to disconnect electrical currents,
**characterized in that**
the predetermined sequence has the following temporally successive steps:
- first switching on of the semiconductor switch (S10) as soon as the opening process is initiated,
- first switching off of the semiconductor switch (S12, S14, S16, S18),
- second switching on of the semiconductor switch after a predetermined switch-off time has elapsed (S20, S22) and
- second switching off of the semiconductor switch after a predetermined current conduction time has elapsed (S24, S26)
and a current transformer (60) being provided for detecting the current flow through the semiconductor switch and generating a corresponding signal when the current flow from the first mechanical contact arrangement (10) to the semiconductor switch (20) commutates, the signal being supplied to the switching electronics system, and the step of first switching off of the semiconductor switch having the following steps:
if the maximum actuation time (t1) of the semiconductor switch (20) is reached (S12, "yes"), switching off (S18) of the semiconductor switch (20), and if the maximum actuation time (t1) of the semiconductor switch (20) is not reached (S12, "no") and if the current flow from the first mechanical contact arrangement (10) to the semiconductor switch (20) has commutated (S14, "yes"), switching off (S18) of the semiconductor switch (20) after a further predetermined current guiding time (t2) has elapsed after the signal has been received from the current transformer (S16).

7. Method according to claim 6, **characterized in that** it is carried out by a switching electronics system (50) designed to switch the semiconductor switch (20) on and off, the switching electronics system (50) being implemented in particular by a processor and a memory in which a program is stored which configures the processor to carry out a method according to claim 6.

## Revendications

1. Dispositif de commutation pour acheminer et couper des courants électriques comprenant
- un premier agencement de contacts mécaniques (10),
- un premier commutateur à semiconducteur (20), qui est monté en parallèle par rapport au premier agencement de contacts mécaniques,
- un deuxième ensemble de contacts mécaniques (30), qui est monté en série par rapport au premier agencement de contacts mécaniques,
- une bobine auxiliaire (40), qui est séparée galvaniquement du circuit électrique d'un entraînement de commutation pour le déplacement des contacts des premier et deuxième ensembles de contacts mécaniques et est couplée électromagnétiquement à une bobine de l'entraînement de commutation, de sorte qu'une tension soit produite dans celle-ci lors de l'arrêt de l'alimentation en tension de l'entraînement de commutation et
- une électronique de commutation (50), qui est formée pour allumer et arrêter le commutateur à semiconducteur (20) et est alimentée par la tension produite dans la bobine auxiliaire lors de l'arrêt de l'alimentation en tension de l'entraînement de commutation, **caractérisé en ce que**
l'électronique de commutation (50) est formée pour allumer et éteindre de nouveau plusieurs fois le commutateur à semiconducteur (20) selon une séquence prédéfinie pendant un processus d'ouverture du premier et du deuxième ensemble de contacts mécaniques (10, 30) pour séparer les courants électriques,
dans lequel la séquence prédéfinie présente les étapes consécutives dans le temps suivantes :
- premier allumage du commutateur à semiconducteur (S10), dès que l'électronique de commutation est alimentée par une tension de la bobine auxiliaire,
- premier arrêt du commutateur à semiconducteur (S12, S14, S16, S18),
- second allumage du commutateur à semiconducteur après expiration d'un temps d'arrêt prédéfini (S20, S22) et
- second arrêt du commutateur à semiconducteur après expiration d'un temps de conduction de courant prédéfini (S24, S26),
et dans lequel un transformateur de courant (60) pour détecter le flux de courant à travers le commutateur à semiconducteur et générer un signal correspondant, lorsque le flux de courant est commuté du premier agencement de contacts mécaniques (10) au commutateur à semiconducteur (20), est prévu, auquel le signal de l'électronique de commutation est fourni et l'étape de premier arrêt du commutateur à semiconducteur présente les étapes suivantes :
au cas où la durée de commande maximale (t1) du commutateur à semiconducteur (20) est atteinte (S12, « oui »), arrêt (S18) du commutateur à semiconducteur (20) et, au cas où la durée de commande maximale (t1) du commutateur à semiconducteur (20) n'est pas atteinte (S12, « non ») et au cas où le flux de courant a commuté du premier agencement de contacts mécaniques (10) au commutateur à semiconducteur (20) (S14, « oui »), arrêt (S18) du commutateur à semiconducteur (20) après expiration d'un autre temps de conduction de courant prédéfini (t2) après réception du signal en provenance du transformateur de courant (S16).

2. Dispositif de commutation selon la revendication 1,
**caractérisé en ce que**
l'autre temps de conduction de courant prédéfini est mesurée de manière à correspondre environ à une durée de temps jusqu'à l'ouverture des contacts des premier et deuxième ensembles de contacts mécaniques.

3. Dispositif de commutation selon la revendication 1 ou 2,
**caractérisé en ce que**
le temps de conduction de courant prédéfini est mesuré de manière à correspondre environ à une durée de temps jusqu'à ce qu'un courant électrique puisse commuter, en raison d'un arc électrique formé, le cas échéant, entre les contacts ouverts des premier et deuxième ensembles de contacts mécaniques pendant le processus d'ouverture, vers le commutateur à semiconducteur.

4. Dispositif de commutation selon l'une quelconque des revendications précédentes,
**caractérisé en ce que**
l'électronique de commutation est formée pour allumer le commutateur à semiconducteur pour la deuxième fois après une durée de temps qui est mesurée de manière à ce que les premier et deuxième ensembles de contacts mécaniques soient totalement ouverts par le processus d'ouverture.

5. Appareil de commutation comprenant
- un dispositif de commutation selon l'une quelconque des revendications précédentes et
- un entraînement de commutation pour le déplacement de contacts des premier et deuxième ensembles de contacts mécaniques.

6. Procédé de commande d'un commutateur à semiconducteur (20) d'un dispositif de commutation pour acheminer et couper des courants électriques, qui présente un premier agencement de contacts mécaniques (10), le commutateur à semiconducteur (20), qui est monté en parallèle par rapport au premier agencement de contacts mécaniques, un deuxième ensemble de contacts mécaniques (30), qui est monté en série par rapport au premier agencement de contacts mécaniques, dans lequel, selon le procédé, le commutateur à semiconducteur (20) est allumé et arrêté plusieurs fois selon une séquence prédéfinie pendant un processus d'ouverture du premier et du deuxième ensemble de contacts mécaniques (10, 30) pour couper les courants électriques,
**caractérisé en ce que**
la séquence prédéfinie présente les étapes consécutives dans le temps suivantes :
- premier allumage du commutateur à semiconducteur (S10), dès que le processus d'ouverture est lancé,
- premier arrêt du commutateur à semiconducteur (S12, S14, S16, S18),
- second allumage du commutateur à semiconducteur après expiration d'un temps d'arrêt prédéfini (S20, S22) et
- second arrêt du commutateur à semiconducteur après expiration d'un temps de conduction de courant prédéfini (S24, S26)
et dans lequel un transformateur de courant (60) pour détecter le flux de courant à travers le commutateur à semiconducteur et générer un signal correspondant, lorsque le flux de courant est commuté du premier agencement de contacts mécaniques (10) au commutateur à semiconducteur (20), est prévu, auquel le signal de l'électronique de commutation est fourni et l'étape de premier arrêt du commutateur à semiconducteur présente les étapes suivantes :
au cas où la durée de commande maximale (t1) du commutateur à semiconducteur (20) est atteinte (S12, « oui »), arrêt (S18) du commutateur à semiconducteur (20) et, au cas où la durée de commande maximale (t1) du commutateur à semiconducteur (20) n'est pas atteinte (S12, « non ») et au cas où le flux de courant a commuté du premier agencement de contacts mécaniques (10) au commutateur à semiconducteur (20) (S14, « oui »), arrêt (S18) du commutateur à semiconducteur (20) après expiration d'un autre temps de conduction de courant prédéfini (t2) après réception du signal en provenance du transformateur de courant (S16).

7. Procédé selon la revendication 6, **caractérisé en ce qu'**il est réalisé par une électronique de commutation (50) conçue pour l'allumage et l'arrêt du commutateur à semi-conducteur (20), dans lequel l'électronique de commutation (50) est en particulier mise en oeuvre par un processeur et une mémoire, dans laquelle un programme est mémorisé, qui configure le processeur pour l'exécution d'un procédé selon la revendication 6.
